(19) Europäisches Patentamt
European Patent Office
Office européen des brevets

(11) EP 4 586 787 A1

(12) EUROPEAN PATENT APPLICATION

(43) Date of publication:
16.07.2025 Bulletin 2025/29

(21) Application number: 24214153.9

(22) Date of filing: 20.11.2024

(51) International Patent Classification (IPC):
H10K 59/38 (2023.01)          H10K 59/80 (2023.01)

(52) Cooperative Patent Classification (CPC):
H10K 59/38; H10K 59/875

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 15.01.2024 KR 20240005867

(71) Applicant: Samsung Display Co., Ltd.
Yongin-si, Gyeonggi-do 17113 (KR)

(72) Inventors:
• KIM, Taeho
Yongin-si (KR)
• KWON, Ohjeong
Yongin-si (KR)
• SON, Jongho
Yongin-si (KR)
• KIM, Daewon
Yongin-si (KR)
• LEE, Mihwa
Yongin-si (KR)
• JANG, Sunggyu
Yongin-si (KR)

(74) Representative: Marks & Clerk LLP
15 Fetter Lane
London EC4A 1BW (GB)

(54) **DISPLAY PANEL AND ELECTRIC DEVICE INCLUDING THE SAME**

(57) A display panel includes a base substrate (SUB) including a pixel circuit (PXC), a pixel electrode (PE) disposed on the base substrate (SUB), a middle layer (ML) disposed on the pixel electrode (PE), the middle layer (ML) including a light emitting material, a color filter (CF) disposed on the middle layer (ML), the color filter (CF) including a phase retardation material which retards a phase of incident light, and a polarizing layer (WGP) disposed on the color filter, the polarizing layer (WGP) including a plurality of grid patterns spaced apart from each other at a selectable interval.

FIG. 2

EP 4 586 787 A1

**Description**

BACKGROUND

1. Technical Field

The disclosure relates to a display panel. For example, the disclosure relates to a display panel and an electric device including the display panel.

2. Description of the Related Art

As information technology develops, the importance of a display device as a connection medium between a user and information is being highlighted.

Recently, a head-mounted display (HMD) including such a display device has been developed. A head-mounted display is a glasses-type monitor device of virtual reality (VR) or augmented reality (AR) which is worn in the form of glasses, a helmet, etc. and focuses on a distance near a user's eyes. A head-mounted display may provide an image displayed on a display device to the user's eyes through a lens.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

SUMMARY

Embodiments provide a display panel with improved light efficiency and manufacturing process efficiency.

Embodiments provide an electric device including the display panel.

A display panel according to an embodiment includes a base substrate including a pixel circuit; a pixel electrode disposed on the base substrate; a middle layer disposed on the pixel electrode, the middle layer including a light emitting material; a color filter disposed on the middle layer, the color filter including a phase retardation material which retards a phase of incident light; and a polarizing layer disposed on the color filter, the polarizing layer including a plurality of grid patterns spaced apart from each other at a selectable interval.

In an embodiment, the phase retardation material included in the color filter may include a polymer of a reactive mesogen.

In an embodiment, the color filter may have a retardation axis, and convert linearly polarized light into circularly polarized light or convert circularly polarized light into linearly polarized light by delaying light in a direction of the retardation axis.

In an embodiment, the color filter may include a colorant.

In an embodiment, the colorant included in the color filter may be an isotropic colorant.

In an embodiment, the isotropic colorant may be a colorant in which an absorption rate for polarized light parallel to a long axis direction of a molecular structure and an absorption rate for polarized light perpendicular to the long axis direction are same.

In an embodiment, the color filter may have a dichroic ratio of less than about 1.2.

In an embodiment, the color filter may have an in-plane phase difference in a range of about 100 nm to about 450 nm.

In an embodiment, in an absorption spectrum of the color filter for light in a wavelength in a range of about 380 nm to about 780 nm, an absorption value of the color filter may be greater than about 0 and less than or equal to about 2.

In an embodiment, the display panel may further include a partition wall defining an opening, and the color filter may be disposed in the opening defined by the partition wall.

In an embodiment, a difference between a height from an upper surface of the base substrate to a lower surface of the polarizing layer and a height from the upper surface of the base substrate to an upper surface of the pixel electrode may be less than about 3.8 micrometers.

In an embodiment, the display panel may further include a first pixel area where light is emitted at a first chief ray angle and a second pixel area where light is emitted at a second chief ray angle greater than the first chief ray angle, and a horizontal separation distance between a center of an upper surface of the pixel electrode and a center of an upper surface of the color filter in a cross-sectional view of the second pixel area may be greater than a horizontal separation distance between a center of an upper surface of the pixel electrode and a center of an upper surface of the color filter in a cross-sectional view of the first pixel area.

In an embodiment, the second pixel area may be closer to an outer edge of the display panel than the first pixel area.

In an embodiment, the grid patterns may be metal patterns including a metal material.

In an embodiment, the middle layer may have a structure in which at least two or more light emitting layers are stacked each other.

In an embodiment, the middle layer may emit white light.

In an embodiment, the base substrate may be at least one of a silicon wafer including silicon and a sapphire substrate including sapphire.

In an embodiment, the display panel may further include a plurality of micro lenses disposed on the color filter, a planarization layer disposed on the micro lenses and covering the micro lenses, and a cover window disposed on the planarization layer.

An electric device according to an embodiment may include a display panel and an optical member disposed in a path of light emitted from the display panel, the optical member including a lens part; and the display panel may include a base substrate including a pixel circuit; a pixel electrode disposed on the base substrate; a middle layer disposed on the pixel electrode, the middle layer including a light emitting material; a color filter disposed on the middle layer, the color filter including a phase retardation material which retards a phase of incident light and the color filter including a colorant; and a polarizing layer disposed on the color filter, the polarizing layer including a plurality of grid patterns spaced apart from each other at a selectable interval.

In an embodiment, the phase retardation material included in the color filter may include a polymer of a reactive mesogen, and the colorant included in the color filter may be an isotropic colorant.

In an embodiment, the color filter may have a retardation axis, and convert linearly polarized light into circularly polarized light or convert circularly polarized light into linearly polarized light by delaying light in a direction of the retardation axis.

In an embodiment, the display panel may further include a partition wall defining an opening, and the color filter may be disposed in the opening defined by the partition wall.

In the display panel according to embodiments, the display panel includes a color filter including a phase retardation material and a polarizing layer disposed on the color filter and including grid patterns. Accordingly, some of light emitted from a light emitting element may be recycled. In this case, a separate polarizing plate need not be disposed on the display panel. For example, the color filter and the polarizing layer may replace the polarizing plate. Accordingly, light efficiency of the display panel may be improved.

Additionally, because the color filter may include the phase retardation material, a separate phase retardation plate need not be disposed between the color filter and the polarizing layer. For example, the color filter may replace the phase retardation plate. Accordingly, a distance between a pixel electrode of the light emitting element and the polarizing layer in a thickness direction may be reduced. Accordingly, recycling efficiency of light emitted from the light emitting element may be improved. It is to be understood that both the foregoing general description and the following detailed description are explanatory and are intended to provide further explanation of the disclosure as claimed.

At least some of the above and other features of the invention are set out in the claims.

BRIEF DESCRIPTION OF THE DRAWINGS

Illustrative, non-limiting embodiments will be more clearly understood from the following detailed description taken in conjunction with the accompanying drawings in which:

FIG. 1 is a schematic plan view illustrating a display panel according to an embodiment.

FIG. 2 is a schematic cross-sectional view illustrating an example taken along line I-I' of FIG. 1.

FIGS. 3 to 5 are views schematically illustrating various examples of the middle layer included in the light emitting element of FIG. 2.

FIG. 6 is a schematic cross-sectional view illustrating recycled light generated in the display panel of FIG. 2.

FIG. 7 is a schematic cross-sectional view illustrating pixel areas of the display panel of FIG. 1.

FIG. 8 is a schematic plan view illustrating an arrangement structure of pixel electrodes, color filters, and a partition wall of the pixel areas of FIG. 7.

FIGS. 9 to 11 are schematic cross-sectional views illustrating other examples taken along line I-I' of FIG. 1.

FIG. 12 is a schematic perspective view illustrating an electric device according to an embodiment.

FIG. 13 is a side view illustrating an example of the storage part of the electric device of FIG. 12.

DETAILED DESCRIPTION OF THE EMBODIMENTS

Hereinafter, display devices in accordance with embodiments will be described in more detail with reference to the accompanying drawings. The same reference numerals are used for the same components in the drawings, and redundant descriptions of the same components may be omitted.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

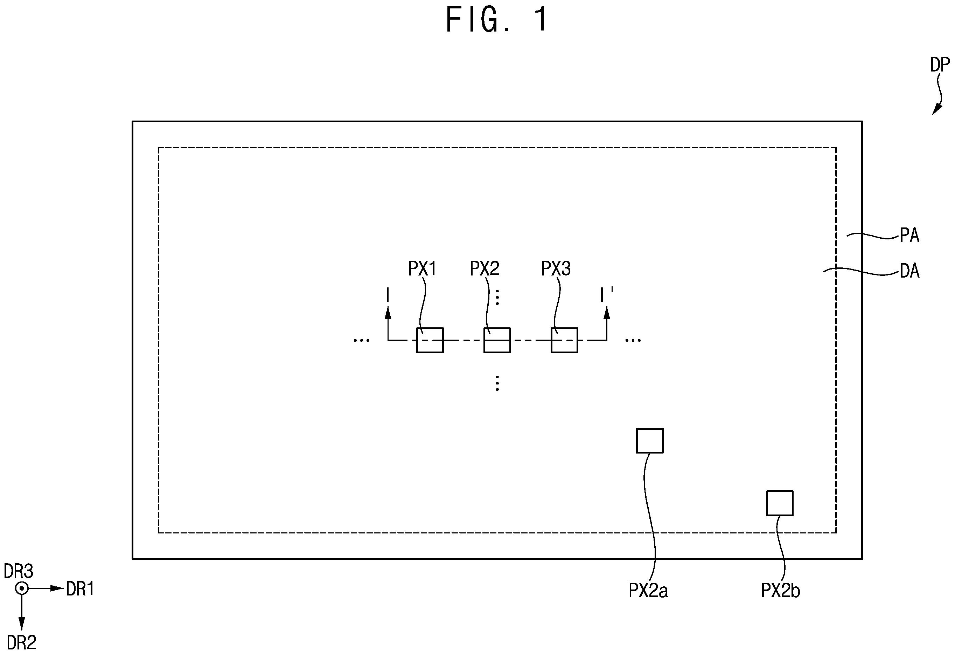

FIG. 1 is a schematic plan view illustrating a display panel according to an embodiment.

Referring to FIG. 1, a display panel DP according to an embodiment of the disclosure may include a display area DA and a peripheral area PA.

The display area DA may be an area which displays an image. A planar shape of the display area DA may be rectangular. However, the planar shape of the display area DA is not limited thereto, and the display area DA may have various planar shapes other than a rectangular shape.

The peripheral area PA may be an area which does not display images. The peripheral area PA may be arranged (or disposed) around the display area DA. For example, the peripheral area PA may entirely surround the display area DA. In an embodiment, drivers for displaying an image in the display area DA may be disposed in the peripheral area PA.

The display area DA may include pixel areas. The pixel areas may be arranged in a matrix form along a first direction DR1 and a second direction DR2 which intersects the first direction DR1. For example, the pixel areas may include a first pixel area PX1, a second pixel area PX2, and a third pixel area PX3.

Each of the first pixel area PX1, the second pixel area PX2, and the third pixel area PX3 may mean an area where light emitted from the light emitting element is emitted to the outside of the display panel DP. For example, the first pixel area PX1 may emit first light, the second pixel area PX2 may emit second light, and the third pixel area PX3 may emit third light. In an embodiment, the first light may be red light, the second light may be green light, and the third light may be blue light. However, the disclosure is not limited thereto.

The display panel DP may have a rectangular planar shape. However, the disclosure is not limited thereto, and the display panel DP may have various planar shapes other than a rectangular shape.

In an embodiment, the display panel DP may be an ultra-small LED display panel (or a micro-LED display panel) which may include ultra-small LEDs (or micro-LEDs) as a light emitting element. However, the disclosure is not limited thereto.

In this specification, a plane may be defined in the first direction DR1 and the second direction DR2. For example, the first direction DR1 may be perpendicular to the second direction DR2. A third direction DR3 may be a normal direction to the plane. For example, the third direction DR3 may be perpendicular to both the first direction DR1 and the second direction DR2.

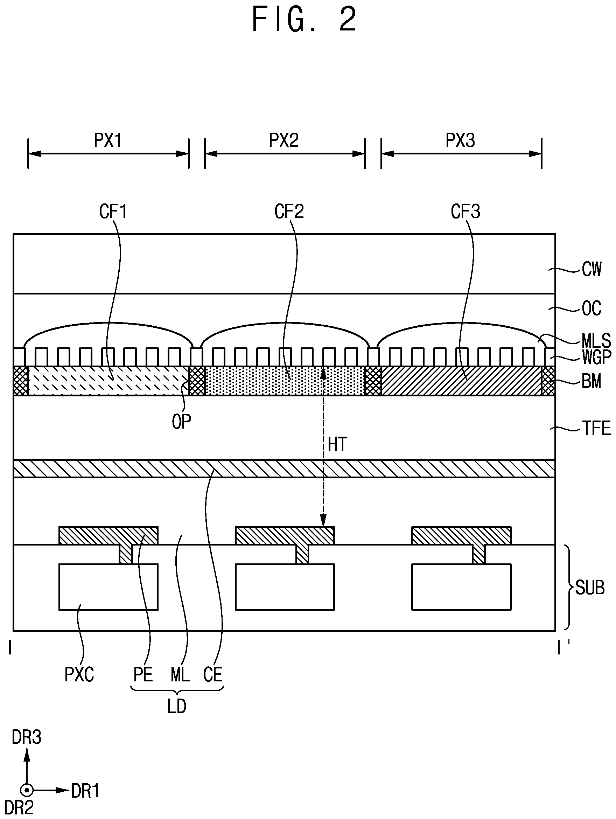

FIG. 2 is a schematic cross-sectional view illustrating an example taken along line I-I' of FIG. 1.

Referring to FIG. 2, the display panel DP may include a base substrate SUB, a light emitting element LD, an encapsulation layer TFE, a partition wall BM, a first color filter CF1, a second color filter CF2, a third color filter CF3, a polarizing layer WGP, micro lenses MLS, a planarization layer OC, and a cover window CW. The light emitting element LD may include a pixel electrode PE, a middle layer ML, and a common electrode CE.

The base substrate SUB may be a semiconductor circuit substrate. The base substrate SUB includes a pixel circuit PXC. The pixel circuit PXC may include various driving elements, wiring, etc. for driving the light emitting element LD. For example, the pixel circuit PXC may include a transistor, capacitor, a gate wire, a data wire, or the like. The pixel circuit PXC may be disposed in each of the first to third pixel areas PX1, PX2, and PX3.

In an embodiment, the base substrate SUB may be a silicon wafer substrate including silicon. By way of example, the base substrate SUB may be a sapphire substrate including sapphire. However, the disclosure is not limited thereto, and the base substrate SUB may include various materials other than silicon and sapphire.

The pixel electrode PE is disposed on the base substrate SUB. The pixel electrode PE may be disposed in each of the first to third pixel areas PX1, PX2, and PX3. For example, the pixel electrode PE may be disposed on the pixel circuit PXC. The pixel electrode PE may be electrically connected to the pixel circuit PXC. For example, the pixel electrode PE may be electrically connected to the pixel circuit PXC through a conductive connection pattern.

The pixel electrode PE may include metal, alloy, metal nitride, conductive metal oxide, transparent conductive material, or the like. These can be used alone or in combination with each other. In an embodiment, the pixel electrode PE may be an anode electrode. The pixel electrode PE may be a reflective electrode.

Although not illustrated, an insulating layer may be disposed between the pixel electrode PE and the base substrate SUB.

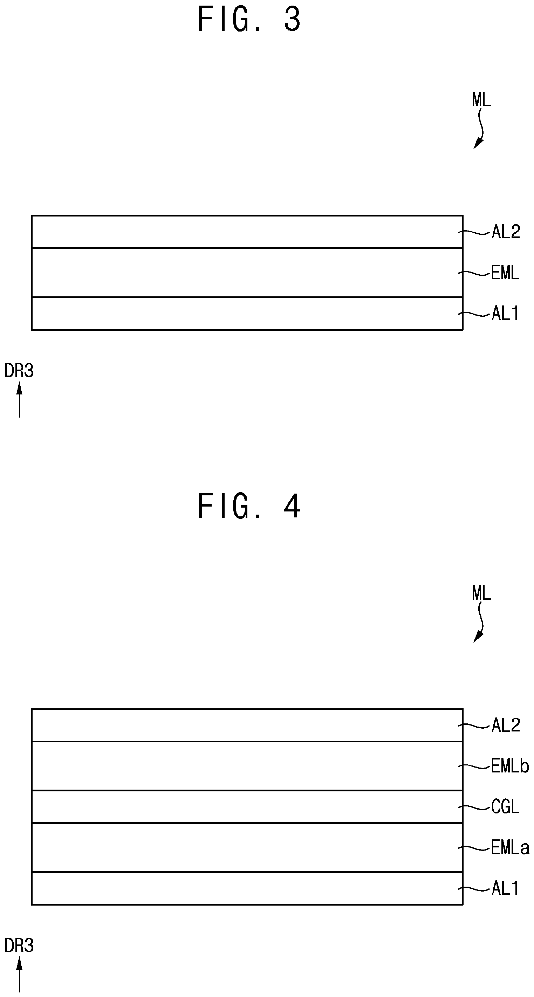

The middle layer ML may be disposed on the base substrate SUB and the pixel electrode PE. In an embodiment, the middle layer ML includes a material which emits light. For example, the middle layer ML may emit white light. A structure of the middle layer ML will be described in more detail later with reference to FIGS. 3 to 5.

The common electrode CE may be disposed on the middle layer ML. The common electrode CE may continuously extend across the first to third pixel areas PX1, PX2, and PX3. For example, the common electrode CE may include metal, alloy, metal nitride, conductive metal oxide, transparent conductive material, or the like. These can be used alone or in combination with each other. In an embodiment, the common electrode CE may be a cathode electrode. The common electrode CE may be a transmissive or semi-transmissive electrode.

The middle layer ML may emit light based on a voltage difference between the pixel electrode PE and the common electrode CE.

FIGS. 3 to 5 are views schematically illustrating various examples of the middle layer included in the light emitting element of FIG. 2.

Hereinafter, various structures of the middle layer ML will be described with reference to FIGS. 3 to 5.

First, referring to FIG. 3, in an embodiment, the middle layer ML may include a first auxiliary layer AL1, a light emitting layer EML, and a second auxiliary layer AL2.

The first auxiliary layer AL1 may be disposed between the pixel electrode PE and the light emitting layer EML. The first auxiliary layer AL1 may be a charge auxiliary layer for controlling injection and/or mobility of charges. The first auxiliary layer AL1 may have a single-layer structure or a multi-layer structure including layers. For example, the first auxiliary layer AL1 may be a hole injection layer, a hole transport layer, an electron blocking layer, an electron injection layer, an electron transport layer, a hole blocking layer, or a combination thereof.

The light emitting layer EML may include a light emitting material. In an embodiment, the light emitting layer EML may emit white light. For example, the light emitting layer EML may include light emitting materials that emit light of different colors, and light emitted by the light emitting materials may be combined to emit white light. The light emitting material included in the light emitting layer EML may be an organic light emitting material, an inorganic light emitting material, or a combination thereof.

The second auxiliary layer AL2 may be disposed between the light emitting layer EML and the common electrode CE. The second auxiliary layer AL2 may be a charge auxiliary layer for controlling injection and/or mobility of charges. The second auxiliary layer AL2 may have a single-layer structure or a multi-layer structure including layers. For example, the second auxiliary layer AL2 may be a hole injection layer, a hole transport layer, an electron blocking layer, an electron injection layer, an electron transport layer, a hole blocking layer, or a combination thereof.

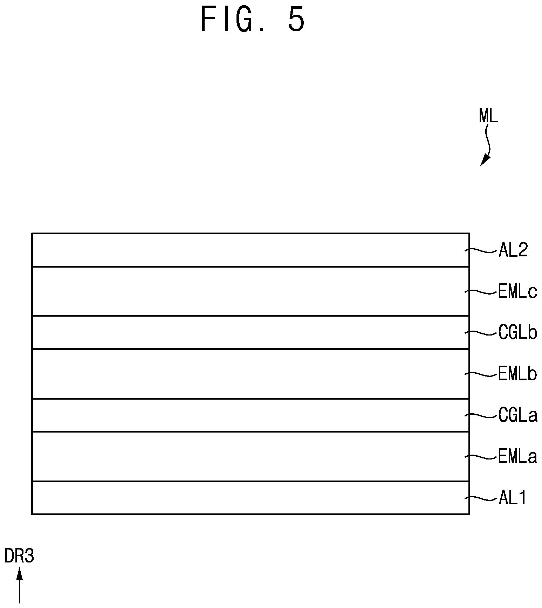

Referring to FIGS. 4 and 5, in an embodiment, the middle layer ML may have a structure in which at least two or more light emitting layers are stacked. For example, the light emitting element LD may be a light emitting element with a tandem structure.

As illustrated in FIG. 4, in an embodiment, the middle layer ML may include the first auxiliary layer AL1, a first light emitting layer EMI,a, a charge generation layer CGL, a second light emitting layer EMI,b, and the second auxiliary layer AL2.

The first auxiliary layer AL1 and the second auxiliary layer AL2 are as described above with reference to FIG. 3.

The first light emitting layer EMI,a may be disposed between the first auxiliary layer AL1 and the charge generation layer CGL, and the second light emitting layer EMI,b may be disposed between the charge generation layer CGL and the second auxiliary layer AL2. The first light emitting layer EMI,a and the second light emitting layer EMI,b may include a light emitting material. The first light emitting layer EMI,a and the second light emitting layer EMI,b may emit light of the same or different colors. Accordingly, the middle layer ML may emit white light obtained by mixing light emitted from the first light emitting layer EMI,a and light emitted from the second light emitting layer EMI,b. For example, the first light emitting layer EMI,a may emit blue light, and the second light emitting layer EMI,b may emit green light. However, the disclosure is not necessarily limited thereto, and a color of light emitted by each of the first and second light emitting layers EMI,a and EMI,b may be variously changed. The light emitting material included in each of the first light emitting layer EMI,a and the second light emitting layer EMLb may be an organic light emitting material, an inorganic light emitting material, or a combination thereof.

The charge generation layer CGL may be disposed between the first light emitting layer EMLa and the second light emitting layer EMI,b. The charge generation layer CGL may inject charges into the first light emitting layer EMI,a and/or the second light emitting layer EMI,b. The charge generation layer CGL may control charge balance between the first light emitting layer EMLa and the second light emitting layer EMI,b. For example, the charge generation layer CGL may include an n-type semiconductor layer and a p-type semiconductor layer, and may include an electron transport material and/or a hole transport material including an n-type dopant and/or a p-type dopant. The charge generation layer CGL may have a single-layer structure or a multi-layer structure in which layers are stacked.

As illustrated in FIG. 5, in an embodiment, the middle layer ML may include the first auxiliary layer AL1, a first light emitting layer EMI,a, a first charge generation layer CGLa, a second light emitting layer EMI,b, a second charge generation layer CGLb, a third light emitting layer EMLc, and the second auxiliary layer AL2.

The first auxiliary layer AL1 and the second auxiliary layer AL2 are as described above with reference to FIG. 3.

The first light emitting layer EMI,a, the second light emitting layer EMI,b, and the third light emitting layer EMI,c of FIG. 5 may include a light emitting material. The first light emitting layer EMI,a, the second light emitting layer EMI,b, and the third light emitting layer EMI,c of FIG. 5 may emit light of the same or different colors. Accordingly, the middle layer ML may emit white light obtained by mixing light emitted from the first light emitting layer EMI,a, light emitted from the second light emitting layer EMI,b, and light emitted from the third light emitting layer EMI,c of FIG. 5. For example, the first light emitting layer EMI,a, the second light emitting layer EMI,b, and the third light emitting layer EMI,c of FIG. 5 may emit blue light. For another example, the first light emitting layer EMI,a and the third light emitting layer EMI,c of FIG. 5 may emit blue light, and the second light emitting layer EMLb of FIG. 5 may emit green light. For another example, the first light emitting layer EMI,a and the third light emitting layer EMLc of FIG. 5 may emit green light, and the second light emitting layer EMI,b of FIG. 5 may emit blue light. However, the disclosure is not necessarily limited thereto, and a color of light emitted by each of the first light emitting layer EMLa, the second light emitting layer EMI,b, and the third light emitting layer EMI,c of FIG. 5 may be variously changed. The light emitting material included in each of the first light emitting layer EMI,a, the second light emitting layer EMI,b, and the third light emitting layer EMI,c of FIG. 5 may be an organic light emitting material, an inorganic light emitting material, or a combination thereof.

The first charge generation layer CGLa may be disposed between the first light emitting layer EMLa and the second light emitting layer EMI,b. The first charge generation layer CGLa may inject charges into the first light emitting layer EMI,a and/or the second light emitting layer EMI,b. The first charge generation layer CGLa may control charge balance between the first light emitting layer EMI,a and the second light emitting layer EMI,b. For example, the first charge generation layer CGLa may include an n-type semiconductor layer and a p-type semiconductor layer, and may include an electron transport material and/or a hole transport material including an n-type dopant and/or a p-type dopant. The first charge generation layer CGLa may have a single-layer structure or a multi-layer structure in which layers are stacked each other.

The second charge generation layer CGLb may be disposed between the second light emitting layer EMLb and the third light emitting layer EMI,c. The second charge generation layer CGLb may inject charges into the second light emitting layer EMI,b and/or the third light emitting layer EMI,c. The second charge generation layer CGLb may control charge balance between the second light emitting layer EMI,b and the third light emitting layer EMI,c. For example, the second charge generation layer CGLb may include an n-type semiconductor layer and a p-type semiconductor layer, and may include an electron transport material and/or a hole transport material including an n-type dopant and/or a p-type dopant. The second charge generation layer CGLb may have a single-layer structure or a multi-layer structure in which layers are stacked each other.

The structure of the middle layer ML described with reference to FIGS. 3 to 5 is only an example, the disclosure is not necessarily limited thereto, and may be determined in various ways depending on embodiments. For example, the middle layer ML may include four or more light emitting layers.

In an embodiment, the structure of the middle layer ML may be individually determined for each of the first to third pixel areas PX1, PX2, and PX3. For example, a structure of the light emitting element LD in the first pixel area PX1, a structure of the light emitting element LD in the second pixel area PX2, and a structure of the light emitting element LD in the third pixel area PX3. may be the same as or different from each other.

Referring again to FIG. 2, the encapsulation layer TFE may be disposed on the common electrode CE. The encapsulation layer TFE may include at least one inorganic encapsulation layer and/ or at least one organic encapsulation layer. The encapsulation layer TFE may prevent foreign substances from penetrating into the light emitting element LD.

The partition wall BM may be disposed on the encapsulation layer TFE. The partition wall BM may define the first pixel area PX1, the second pixel area PX2, and the third pixel area PX3. For example, the partition wall BM may define openings OP which partition the first pixel area PX1, the second pixel area PX2, and the third pixel area PX3.

In an embodiment, the partition wall BM may include a light blocking material. Examples of the light blocking material that can be used as the partition wall BM may include organic and/or inorganic materials including black pigment, black dye, or the like. However, the disclosure is not necessarily limited thereto, and the partition wall BM may include a reflective material such as a metal material. Accordingly, the partition wall BM may prevent color mixing between the first to third pixel areas PX1, PX2, and PX3.

The first to third color filters CF1, CF2, and CF3 may be disposed in the openings OP defined by the partition wall BM. The first color filter CF1 may be disposed in the first pixel area PX1, the second color filter CF2 may be disposed in the second pixel area PX2, and the third color filter CF3 may be disposed in the third pixel area PX3.

Each of the first to third color filters CF1, CF2, and CF3 may selectively transmit only light of a given wavelength and absorb light of the remaining wavelengths. For example, the first color filter CF1 may selectively transmit red light, the second color filter CF2 may selectively transmit green light, and the third color filter CF3 may selectively transmit blue light. Accordingly, red light may be emitted from the first pixel area PX1, green light may be emitted from the second pixel area PX2, and blue light may be emitted from the third pixel area PX3. However, the disclosure is not necessarily limited thereto.

Each of the first to third color filters CF1, CF2, and CF3 may include a phase retardation material. The phase retardation material may delay a phase of light incident on each of the first to third color filters CF1, CF2, and CF3.

In an embodiment, the phase retardation material included in the first to third color filters CF1, CF2, and CF3 may include a polymer of reactive mesogen. The reactive mesogen may be a mesogen including reactive group which can induce polymerization by light or heat, for example, a mesogen including a polymerizable functional group. Here, the mesogen may be a meso phase compound which can express liquid crystal phase behavior in case that the reactive mesogen is polymerized. The polymerizable functional group may be a functional group reactive to heat or light which can induce polymerization of the liquid crystal compound.

In an embodiment, the reactive mesogen may be a mesogen having two or more of the polymerizable functional groups and, for example, may have a structure of Formula 1 or Formula 2 below.

[Formula 1]        B-Cn-A-Cn-B

[Formula 2]        B-A-Cn-A-B

In Formulas 1 and 2, B may refer to a polymerizable functional group, A may refer to a mesogenic group, and Cn may refer to a linking group.

Here, the linking group may connect the polymerizable functional group to the mesogenic group. For example, the linking group may be in a form of -(D-E)n-, D may be a linear or branched alkylene group having 1 to 12 carbon atoms, E may be oxygen or sulfur, and n may be an integer from 1 to 5.

Examples of the polymerizable functional group may include (meth)acrylate, (meth)acrylamide, acrylonitrile, styrene, an alkyl group, a cyano group, an alkoxy group, a vinyl group, or the like. However, the disclosure is not necessarily limited thereto, and any functional group reactive to heat or light may be used without limitation.

Examples of the mesogenic group may include a calamitic mesogenic group or a discotic mesogenic group for example.

The calamitic mesogenic group may be a rod-shape including one or more aromatic or aliphatic rings connected in one direction or a direction, and may be a mesogenic group which can be polymerized to form a rod-shaped liquid crystal structure. The calamitic mesogenic group may include one or more functional groups at an end or side of the rod-shape.

The discotic mesogenic group may be a mesogenic group having a planar core structure including one or more aromatic or aliphatic rings, and may be a mesogenic group which can be polymerized to form a discotic liquid crystal structure.

The polymer of the reactive mesogen may form a polymer network. For example, in case that the reactive mesogen is polymerized, a cross-linked polymer network may be formed while maintaining an aligned phase of the liquid crystal. The polymer network may be mechanically and thermally stable because the polymer network has a form of a solid thin film while retaining characteristics of liquid crystal, such as optical anisotropy and dielectric constant.

However, the phase retardation material included in the first to third color filters CF1, CF2, and CF3 is not limited to the materials described above. For example, the phase retardation material may be a material which can be mixed with a colorant included in the first to third color filters CF1, CF2, and CF3, and may be any material as long as delaying a phase of incident light.

For example, the phase retardation material may include polyolefin such as polyethylene (PE) or polypropylene (PP), cyclo olefin polymer (COP) such as polynorbornene, polyester such as polyvinyl chloride (PVC), polyacrylonitrile (PAN), polysulfone (PSU), acryl resin, polycarbonate (PC), or polyethylene terephthalate (PET), cellulose ester polymer such as polyacrylate, polyvinyl alcohol (PVA), or triacetyl cellulose (TAC), polystyrene, copolymers of two or more types of monomers from among monomers which form them. These can be used alone or in combination with each other.

For example, a method of obtaining the first to third color filters CF1, CF2, and CF3 including the polymer material is not particularly limited, and the method of obtaining the first to third color filters CF1, CF2, and CF3 is not particularly limited. The first to third color filters CF1, CF2, and CF3 may be obtained by molding the first to third color filters CF1, CF2, and CF3 into a film form and stretching them. A method of forming the film form is not particularly limited.

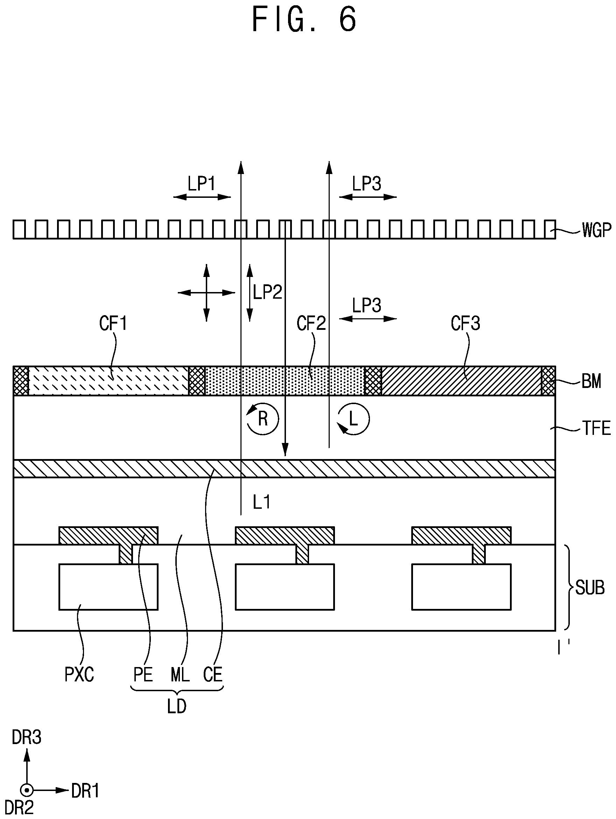

As each of the first to third color filters CF1, CF2, and CF3 may include the phase retardation material, the first to third color filters CF1, CF2, and CF3 may function as a phase retardation layer. For example, each of the first to third color filters CF1, CF2, and CF3 may have a retardation axis and provide a phase difference with respect to the retardation axis. For example, each of the first to third color filters CF1, CF2, and CF3 may convert linearly polarized light into circularly polarized light or convert circularly polarized light into linearly polarized light by delaying light in a direction of the retardation axis. By way of example, each of the first to third color filters CF1, CF2, and CF3 may provide a phase difference of $\lambda/4$ or $3\lambda/4$. Accordingly, each of the first to third color filters CF1, CF2, and CF3 may convert linearly polarized light into circularly polarized light or convert circularly polarized light into linearly polarized light by delaying light in a direction of the retardation axis by $\lambda/4$ or $3\lambda/4$. This will be described in more detail later with reference to FIG. 6.

Each of the first to third color filters CF1, CF2, and CF3 may include a colorant. Examples of the colorant included in the first to third color filters CF1, CF2, and CF3 may include pigments and dyes.

In an embodiment, the first to third color filters CF1, CF2, and CF3 may include colorant of different series. For example, the first color filter CF1 may include a colorant of a first color series, the second color filter CF2 may include a colorant of a second color series, and the third color filter CF3 may include a colorant of a third color series. In an embodiment, the first color may be red, the second color may be green, and the third color may be blue. For example, the first color filter CF1 may include a colorant of a red color series and selectively transmit red light. The second color filter CF2 may include a colorant of a green color series and selectively transmit green light. The third color filter CF3 may include a colorant of blue series and selectively transmit blue light. However, the disclosure is not necessarily limited thereto.

As a result, according to embodiments, each of the first to third color filters CF1, CF2, and CF3 may include both the phase retardation material and the colorant. Accordingly, the first to third color filters CF1, CF2, and CF3 may not only convert a color of light emitted from the light emitting element LD, but also delay a phase of incident light. Accordingly, the display panel DP need not include a separate phase retardation plate. For example, the first to third color filters CF1, CF2, and CF3 may replace the phase retardation plate.

The colorant included in the first to third color filters CF1, CF2, and CF3 may be an isotropic colorant. The isotropic colorant may be a colorant in which an absorption rate for polarized light parallel to a long axis direction of a molecular structure and an absorption rate for polarized light perpendicular to the long axis direction may be substantially the same. For example, the isotropic colorant may be a colorant which does not have a rectangular molecular structure extending long in any one direction or a direction.

By way of example, the isotropic colorant may be a colorant which does not express dichroism in case that it is mixed with the phase retardation material. For example, the isotropic colorant may implement a low dichroic ratio of each of the first to third color filters CF1, CF2, and CF3 as mixed with the phase retardation material. Since the dichroism may cause a decrease in light extraction efficiency, color, and phase delay, it is not expressed in the first to third color filters CF1, CF2, and CF3.

In other words, even in case that each of the first to third color filters CF1, CF2, and CF3 may include the phase retardation material and the colorant, since the colorant included in the first to third color filters CF1, CF2, and CF3 is an isotropic colorant, dichroism need not appear in the first to third color filters CF1, CF2, and CF3. Accordingly, light extraction efficiency, color, and phase delay of the first to third color filters CF1, CF2, and CF3 need not be deteriorated.

In embodiments, the dichroic ratio of each of the first to third color filters CF1, CF2, and CF3 may be less than about 1.2. By way of example, the dichroic ratio of each of the first to third color filters CF1, CF2, and CF3 may substantially converge to about 1. The dichroic ratio of each of the first to third color filters CF1, CF2, and CF3 may be about 1. The dichroic ratio may be calculated by Equation 1 below.

[Equation 1]

$$DR = Log(1/T_\perp)/Log(1/T_\parallel)$$

In Equation 1, DR is the dichroic ratio of each of the first to third color filters CF1, CF2, and CF3, and $T_\perp$ is a light transmittance of each of the first to third color filters CF1, CF2, and CF3 for light incident perpendicular to a transmission axis of each of the first to third color filters CF1, CF2, and CF3, and $T_\parallel$ is a light transmittance of each of the first to third color filters CF1, CF2, and CF3 for light incident parallel to the transmission axis of each of the first to third color filters CF1, CF2, and CF3.

For example, in the embodiments, since the colorant included in the first to third color filters CF1, CF2, and CF3 is an isotropic colorant, dichroism may not appear in the first to third color filters CF1, CF2, and CF3. Accordingly, light extraction efficiency, color, and phase delay of the first to third color filters CF1, CF2, and CF3 need not be deteriorated.

Examples of the isotropic colorant may include phthalocyanine-based compounds, tetra aza porphyrin (TAP)-based compounds, porphyrin-based compounds, anthraquinone-based compounds, or a compound having a molecular skeleton of a combination thereof. These can be used alone or in combination with each other.

In embodiments, an in-plane phase difference (Ro) of each of the first to third color filters CF1, CF2, and CF3 may be in a range of about 100 nm to about 450 nm, for example, in a range of about 100 nm to about 200 nm, and for further example in a range of about 100 nm to about 150 nm.

The in-plane phase difference (Ro) may be calculated by Equation 2 below.

[Equation 2]

$$Ro = \{|n_x - n_y|\} \times d$$

In Equation 2, nx is a refractive index in one axial (x-axis) direction in a plane of a layer (for example, color filters CF1, CF2, CF3), ny is a refractive index in another axis (y-axis) direction orthogonal to the one axis in the plane of the layer, and d is a thickness of the layer. A phase difference value may represent a value at a given wavelength. For example, in this specification, the phase difference value may be a value at a wavelength of about 550 nm.

In case that the in-plane phase difference (Ro) of each of the first to third color filters CF1, CF2, and CF3 satisfies the above-mentioned range, each of the first to third color filters CF1, CF2, and CF3 may have excellent phase retardation characteristics, and color unevenness problems caused by phase difference may be prevented. For example, even in case that each of the first to third color filters CF1, CF2, and CF3 may include both the phase retardation material and the colorant, each of the first to third color filters CF1, CF2, and CF3 may express phase retardation characteristics sufficient to replace the phase retardation plate. In this specification, the in-plane phase difference (Ro) may be a value for light with a wavelength of about 550 nm.

In an absorption spectrum for light in a wavelength in a range of about 380 nm to about 780 nm, an absorption value of each of the first to third color filters CF1, CF2, and CF3 may be greater than about 0 and less than or equal to about 2. By way of example, the absorption value may be about 1 to about 2.

The absorption value may be determined from the absorption spectrum (or spectroscopic analysis for light in a wavelength in a range of about 380 nm to about 780 nm) using a commercial spectrometer (for example, Cary series from Agilent Technology or products available from Shimadzu).

In the spectroscopic analysis, the absorption value may be calculated by Equation 3 below.

[Equation 3]

$$AV = Log(I_0/I)$$

In Equation 3, AV is the absorption value of each of the first to third color filters CF1, CF2, and CF3, I is an intensity after light of a given wavelength passes through a sample (for example, any one of the first to third color filters CF1, CF2, and CF3), and $I_0$ is an intensity before light of the given wavelength is incident on the sample.

In the case that the absorption value of each of the first to third color filters CF1, CF2, and CF3 satisfies the above-mentioned range, a light passing through the first to third color filters CF1, CF2, and CF3 may have excellent color. For example, even in case that each of the first to third color filters CF1, CF2, and CF3 may include both the phase retardation material and the colorant, color of light transmitted through the first to third color filters CF1, CF2, and CF3 and emitted through the first to third pixel areas PX1, PX2, and PX3 may not deteriorate.

The polarizing layer WGP may be disposed on the partition wall BM and the first to third color filters CF1, CF2, and CF3. The polarizing layer WGP includes grid patterns. The grid patterns are spaced apart from each other at a selectable interval. For example, the grid patterns may be spaced apart from each other in a first direction DR1. In an embodiment, the grid patterns may be metal patterns including a metal material. For example, the polarizing layer WGP may be a wire grid polarizing layer. In an embodiment, a space between two of the adjacent grid patterns may be filled with a material of a layer which is disposed on the polarizing layer WGP (e.g., a material of the micro lenses MI,S). In another embodiment, the space between two of the adjacent grid patterns may be empty.

Each of the grid patterns of the polarizing layer WGP may extend in parallel in one direction or a direction (for example, the second direction DR2). For example, light incident perpendicular to the direction in which the polarizing layer WGP extends may pass through the polarizing layer WGP. In contrast, light incident parallel to the direction in which the polarizing layer WGP extends may be reflected by the polarizing layer WGP. The polarizing layer WGP may include a metal material with a relatively high reflectivity. For example, examples of metal materials that can be used as the polarizing layer WGP may include aluminum (Al), gold (Au), silver (Ag), copper (Cu), chromium (Cr), iron (Fe), nickel. (Ni), or the like. These can be used alone or in combination with each other.

FIG. 6 is a schematic cross-sectional view illustrating recycled light generated in the display panel of FIG. 2.

Referring further to FIG. 6, some of light emitted from the middle layer ML may be recycled by the first to third color filters CF1, CF2, and CF3 and the polarizing layer WGP. As described above, since each of the first to third color filters CF1, CF2, and CF3 delay a phase of incident light, some of light emitted from the middle layer ML may be recycled by the first to third color filters CF1, CF2, and CF3 and the polarizing layer WGP.

Thereafter, a principle of generating recycled light will be explained focusing on the second pixel area PX2. The principle of generating recycled light in the first pixel area PX1 and the third pixel area PX3 may be the same as the principle of generating recycled light in the second pixel area PX2. Therefore, the corresponding description may be omitted.

In FIG. 6, polarization characteristics of a first light L1 emitted from the middle layer ML may be influenced only by the first to third color filters CF1, CF2, and CF3 and the polarizing layer WGP. In an example, as illustrated in FIG. 2, no component is disposed between the first to third color filters CF1, CF2, and CF3 and the polarizing layer WGP, and the polarizing layer WGP may be directly disposed on the first to third color filters CF1, CF2, and CF3. In another example, even in case that another component is disposed between the first to third color filters CF1, CF2, and CF3 and the polarizing layer WGP, the component does not affect the polarization characteristics of the first light L1.

The first light L1 emitted from the middle layer ML may pass through the second color filter CF2. The first light L1 may have polarization characteristics in all directions. The first light L1 passing through the second color filter CF2 may be incident on the polarizing layer WGP. A first linearly polarized light LP1 of the first light L1 incident on the polarizing layer WGP may be passed, and a second linearly polarized light LP2 of the first light L1 incident on the polarizing layer WGP may be reflected. The first linearly polarized light LP1 may be linearly polarized light in a direction perpendicular to the direction in which the grid patterns extend, and the second linearly polarized light LP2 may be linearly polarized light in a direction parallel to the direction in which the grid patterns extend. The second linearly polarized light LP2 reflected from the polarization layer WGP may pass through the second color filter CF2 and be converted into a first circularly polarized light R. For example, the second color filter CF2 may have the retardation axis and convert linearly polarized light into circularly polarized light by delaying light in the direction of the retardation axis. For example, the second color filter CF2 may provide a retardation of $\lambda/4$ to light in the direction of the retardation axis. The first circularly polarized light R may be a right-circularly polarized light.

The first circularly polarized light R may be incident on the common electrode CE and reflected from the common electrode CE so that a phase of the first circularly polarized light R may be reversed by 180 degrees. For example, the first circularly polarized light R may be converted into a second circularly polarized light L. The second circularly polarized light L may be a left-circularly polarized light.

The second circularly polarized light L may pass through the second color filter CF2 and be converted into a third linearly polarized light LP3. For example, the second color filter CF2 may convert circularly polarized light into linearly polarized light by delaying light in the direction of the retardation axis. For example, the second color filter CF2 may provide a delay of $\lambda/4$ to light in the direction of the retardation axis. As a result, the third linearly polarized light LP3 may be a linearly polarized light in a direction perpendicular to the direction in which the grid patterns of the polarization layer WGP extend. Accordingly, the third linearly polarized light LP3 may be incident on the polarizing layer WGP and pass through the polarizing layer WGP.

As a result, since the display panel DP may include the first to third color filters CF1, CF2, and CF3 including the phase retardation material and the polarizing layer WGP including the grid patterns, some of the light emitted from the middle layer ML may be recycled. In this case, a separate polarizing plate need not be disposed on the display panel DP.

For example, the first to third color filters CF1, CF2, and CF3 and the polarizing layer WGP may replace the polarizing plate. Accordingly, light efficiency of the display panel DP may be improved.

As a distance between the pixel electrode PE and the polarizing layer WGP in the third direction DR3 increases, a recycling efficiency of light emitted from the middle layer ML may decrease. By way of example, as a pixel area is closer to an outer edge of the display panel DP, a chief ray angle of light emitted may increase. Accordingly, recycling efficiency may be decreased. Accordingly, light efficiency of the display panel DP may be relatively reduced, and luminance deviation for each pixel area may occur.

According to embodiments of the disclosure, as described above, since the first to third color filters CF1, CF2, and CF3 include the phase retardation material, the first to third color filters CF1, CF2, and CF3 may replace the phase retardation plate. Accordingly, a separate phase retardation plate need not be disposed between the first to third color filters CF1, CF2, and CF3 and the polarizing layer WGP. Accordingly, a distance between the pixel electrode PE and the polarizing layer WGP in the third direction DR3 may be reduced. Accordingly, recycling efficiency of light emitted from the middle layer ML may be improved. By way of example, as the distance between the pixel electrode PE and the polarizing layer WGP decreases in the third direction DR3, recycling efficiency of a pixel area located (or disposed) close to the outer edge of the display panel DP may also improve. Accordingly, light efficiency of the display panel DP may be improved, and luminance deviation for each pixel area of the display panel DP may be reduced or prevented. Accordingly, display quality of the display panel DP may be improved.

As illustrated in FIG. 2, in embodiments, a difference between a height from an upper surface of the base substrate SUB to a lower surface of the polarizing layer WGP and a height from the upper surface of the base substrate SUB to an upper surface of the pixel electrode PE may be less than about 3.8 micrometers. That is, a distance HT in the third direction DR3 from the upper surface of the pixel electrode PE to a lower surface of the polarizing layer WGP may be less than about 3.8 micrometers. In other words, since the first to third color filters CF1, CF2, and CF3 replace the phase retardation plate and a separate phase retardation plate is not disposed, the distance HT in the third direction DR3 from the upper surface of the pixel electrode PE to a lower surface of the polarizing layer WGP may be less than about 3.8 micrometers.

By way of example, the distance HT in the third direction DR3 from the upper surface of the pixel electrode PE to the lower surface of the polarizing layer WGP may be about 2.0 micrometers to about 3.0 micrometers. By way of example, the distance HT in the third direction DR3 from the upper surface of the pixel electrode PE to the lower surface of the polarizing layer WGP may be about 2.5 micrometers. Accordingly, light efficiency of the display panel DP may be further improved.

The micro lenses MLS may be disposed on the polarizing layer WGP. The micro lenses MLS may have a selectable refractive index. For example, the micro lenses MLS may have a refractive index of about 1.5 to about 1.7. However, the disclosure is not limited thereto. The micro lenses MLS may improve light extraction efficiency.

The planarization layer OC may be disposed on the polarizing layer WGP and the micro lenses MLS. The planarization layer OC may include organic and/or inorganic materials. The planarization layer OC may compensate for steps caused by the polarizing layer WGP and/or the micro lenses MLS.

The cover window CW may be disposed on the planarization layer OC. The cover window CW may include tempered glass, reinforced plastic, or the like. Optionally, the cover window CW may be formed as a single layer or may have a structure in which functional layers are stacked each other.

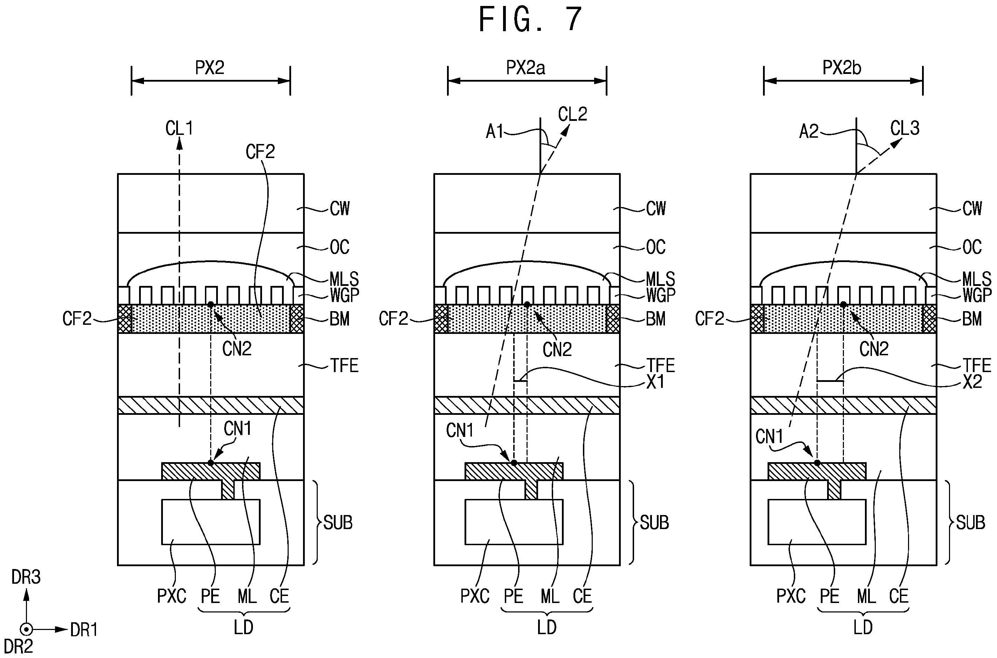

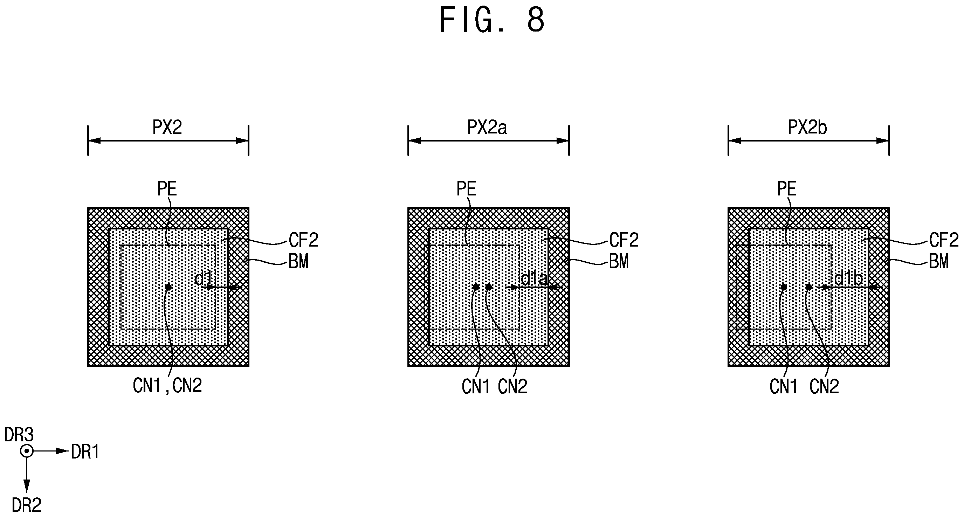

FIG. 7 is a schematic cross-sectional view illustrating pixel areas of the display panel of FIG. 1, and FIG. 8 is a plan view illustrating an arrangement structure of pixel electrodes, color filters, and a partition wall of the pixel areas of FIG. 7.

By way of example, FIG. 7 selectively illustrates a schematic cross-sectional view of three second pixel areas PX2, PX2a, and PX2b with different distances from a center of the display panel DP among the plurality of second pixel areas of the display panel DP. For example, FIG. 8 selectively illustrates a planar arrangement structure of a pixel electrode, a color filter, and a partition wall of each of the three second pixel areas PX2, PX2a, and PX2b of FIG. 7.

Hereinafter, for convenience of description, a second pixel area located in the center among the three second pixel areas PX2, PX2a, and PX2b is referred to as the second pixel area PX2, and the second pixel area furthest from the center is referred to as the second of the second pixel area PX2b, and the remaining second pixel area is referred to as the first of the second pixel area PX2a. The second pixel area PX2 may correspond to the second pixel area PX2 of FIG. 2.

FIGS. 7 and 8 illustrate a structure of the second pixel areas of the display panel DP, but the contents described with reference to FIGS. 7 and 8 are the same for the first pixel area and the third pixel area. Therefore, the corresponding description may be omitted.

Referring to FIGS. 1, 7, and 8, the second of the second pixel area PX2b is closer to the outer edge of the display panel DP than the first of the second pixel area PX2a and the second pixel area PX2. The first of the second pixel area PX2a is closer to the outer edge of the display panel DP than the second pixel area PX2. In other words, the second of the second pixel area PX2b is farther from the center of the display panel DP than the first of the second pixel area PX2a and the second pixel area PX2. The first of the second pixel area PX2a is farther from the center of the display panel DP than the second pixel area PX2.

A first chief light CL1 emitted from the second pixel area PX2 may be emitted without substantial change in an optical path on an emission surface. For example, light emitted from the second pixel area PX2 may be emitted perpendicular to the emission surface at a chief ray angle of 0 degrees.

A second chief light CL2 emitted from the first of the second pixel area PX2a may be emitted forming a first chief ray angle A1 with respect to a normal line of the emission surface. For example, the second chief light CL2 may be emitted at an angle to the emission surface. Accordingly, the first chief ray angle A1 of the light emitted from the first of the second pixel area PX2a may be greater than the chief ray angle of the light emitted from the second pixel area PX2. As described above, as a pixel area closer to the outer edge of the display panel DP, a chief ray angle of light emitted may increase, and accordingly, the first chief ray angle A1 may be greater than the chief ray angle of the light emitted from the second pixel area PX2.

The third chief light CL3 emitted from the second of the second pixel area PX2b may be emitted forming a second chief ray angle A2 with respect to the normal line of the emission surface. For example, the third chief light CL3 may be emitted at an angle to the emission surface. Likewise, as a pixel area closer to the outer edge of the display panel DP, a chief ray angle of light emitted may increase, and accordingly, the second chief ray angle A2 emitted from the second of the second pixel area PX2b may be greater than the first chief ray angle A1 of the light emitted from the first of the second pixel area PX2a.

As illustrated in FIGS. 7 and 8, in the schematic cross-sectional view of the second pixel area PX2, a center CN1 of an upper surface of the pixel electrode PE and a center CN2 of an upper surface of the second color filter CF2 may be aligned on a straight line. On the other hand, in the cross-sectional view of the first of the second pixel area PX2a, a center CN1 of an upper surface of the pixel electrode PE and a center CN2 of an upper surface of the second color filter CF2 may be spaced apart as a first separation distance X1 in a horizontal direction (or, the first direction DR1). For example, a position of the second color filter CF2 is relatively shifted, so that the center CN1 of the upper surface of the pixel electrode PE and the center CN2 of the upper surface of the second color filter CF2 may be not aligned on a straight line in the cross-sectional view of the first of the second pixel area PX2a. In the cross-sectional view of the second of the second pixel area PX2b, a center CN1 of an upper surface of the pixel electrode PE and a center CN2 of an upper surface of the second color filter CF2 may be spaced apart as a second separation distance X2 in the horizontal direction (or, the first direction DR1). For example, a position of the second color filter CF2 is relatively shifted, so that the center CN1 of the upper surface of the pixel electrode PE and the center CN2 of the upper surface of the second color filter CF2 may be not aligned on a straight line in the cross-sectional view of the second of the second pixel area PX2b.

At this time, the larger the pixel area of the chief ray angle of the emitted light, in cross-sectional view, the larger the separation distance in the horizontal direction (or, the first direction DR1). In other words, the closer the pixel area is to the outer edge of the display panel DP, in cross-sectional view, the larger the separation distance in the horizontal direction (or, the first direction DR1) between the center CN1 of the upper surface of the pixel electrode PE and the center CN2 of the upper surface of the second color filter CF2.

For example, in the cross-sectional view of the second pixel area PX2, since the center CN1 of the upper surface of the pixel electrode PE and the center CN2 of the upper surface of the second color filter CF2 are aligned on the straight line, the separation distance may be substantially zero. On the other hand, in the cross-sectional view of the first of the second pixel area PX2a, the center CN1 of the upper surface of the pixel electrode PE and the center CN2 of the upper surface of the second color filter CF2 may be spaced apart as the first separation distance X1 lager than 0 in the horizontal direction (or, the first direction DR1). In the cross-sectional view of the second of the second pixel area PX2b, the center CN1 of the upper surface of the pixel electrode PE and the center CN2 of the upper surface of the second color filter CF2 may be spaced apart as the second separation distance X2 lager than the first separation distance X1 in the horizontal direction (or, the first direction DR1).

For example, as illustrated in FIG. 8, a distance d1 in the horizontal direction (or, the first direction DR1) between an edge of the pixel electrode PE in the horizontal direction (or, the first direction DR1) and the partition wall BM in a plan view of the second pixel area PX2 may be less than a distance d1a in the horizontal direction (or, the first direction DR1) between an edge of the pixel electrode PE in the horizontal direction (or, the first direction DR1) and the partition wall BM in a plan view of the first of the second pixel area PX2a. The distance d1a in the horizontal direction (or, the first direction DR1) between an edge of the pixel electrode PE in the horizontal direction (or, the first direction DR1) and the partition wall BM in a plan view of the first of the second pixel area PX2a may be less than a distance d1b in the horizontal direction (or, the first direction DR1) between an edge of the pixel electrode PE in the horizontal direction (or, the first direction DR1) and the partition wall BM in a plan view of the second of the second pixel area PX2b.

As described above, as a pixel area is closer to the outer edge of the display panel DP, a chief ray angle of light emitted may increase, and accordingly, recycling efficiency of light emitted from the middle layer ML may be lower.

According to embodiments of the disclosure, a degree to which a color filter is shifted may be varied for each pixel area, considering a degree of an angle of a chief ray of light emitted. For example, the larger a chief ray angle of light emitted, the degree to which the color filter is shifted based on the center CN1 of the upper surface of the pixel electrode PE may be increased to prevent recycling efficiency of light emitted from the middle layer ML from being reduced. Accordingly, even in the case of pixel areas located close to the outer edge of the display panel DP and having a relatively large chief ray angle, recycling efficiency of light emitted from the middle layer ML may be not reduced. Accordingly, light efficiency of the display panel DP may be improved, and luminance deviation for each pixel area of the display panel DP may be reduced or prevented. Accordingly, display quality of the display panel DP may be improved.

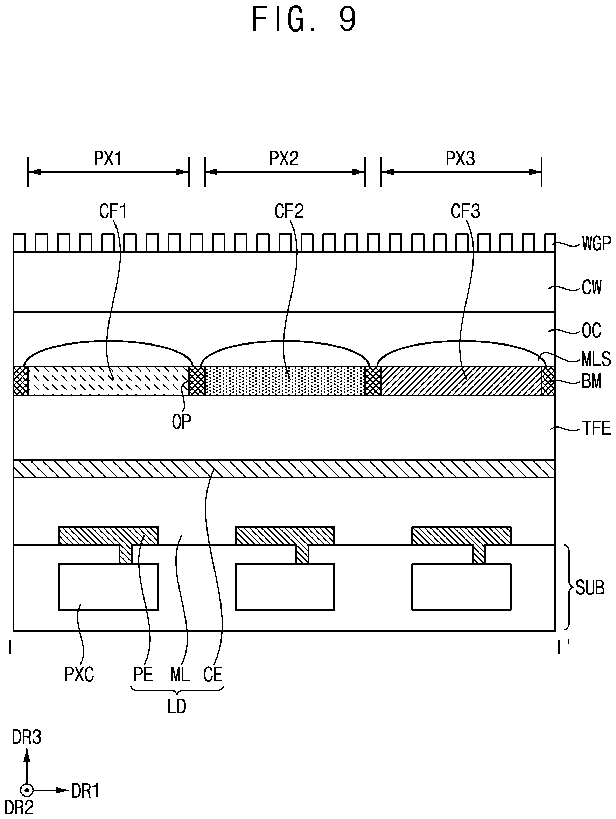

FIGS. 9 to 11 are schematic cross-sectional views illustrating other examples taken along line I-I' of FIG. 1.

An embodiment of the display panel DP described with reference to FIG. 9 may be substantially the same or similar to the embodiment of the display panel DP described above with reference to FIG. 2 except for a position of the polarizing layer WGP. Hereinafter, overlapping descriptions may be omitted or simplified.

Referring to FIG. 9, in an embodiment, the polarizing layer WGP may be disposed on the cover window CW. For example, the first to third color filters CF1, CF2, and CF3, the micro lenses MLS, the planarization layer OC, the cover window CW, and the polarizing layer WGP may be sequentially disposed.

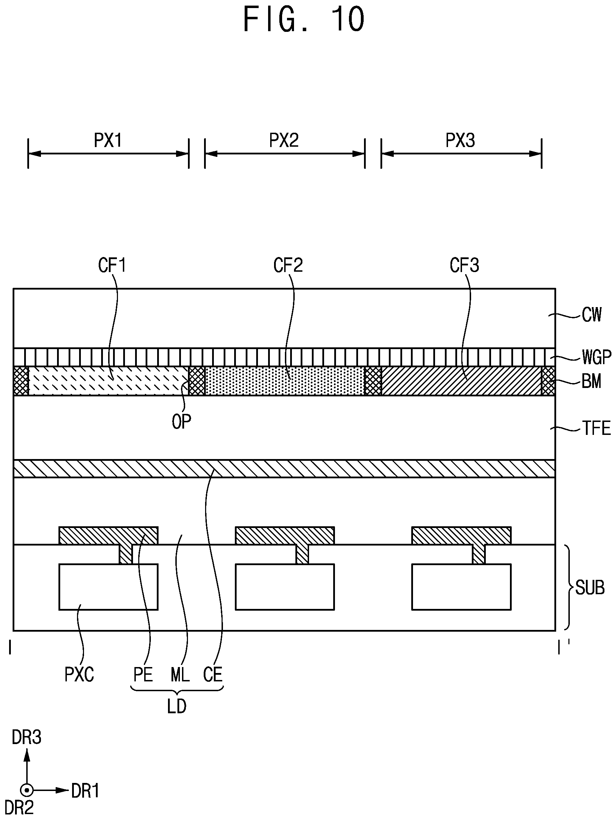

An embodiment of the display panel DP described with reference to FIG. 10 may be substantially the same or similar to the display panel DP described above with reference to FIG. 2 except that the micro lenses MLS described with reference to FIG. 2 may be omitted. Hereinafter, overlapping descriptions may be omitted or simplified.

Referring to FIG. 10, in an embodiment, the micro lenses (MLS, in FIG. 2) may be omitted. The planarization layer (OC, in FIG. 2) may also be omitted. However, the disclosure is not necessarily limited thereto, and the planarization layer OC may be disposed between the polarizing layer WGP and the cover window CW. As the micro lenses MLS may be omitted, a structure of the display panel DP may be simplified and a manufacturing process of the display panel DP may be simplified.

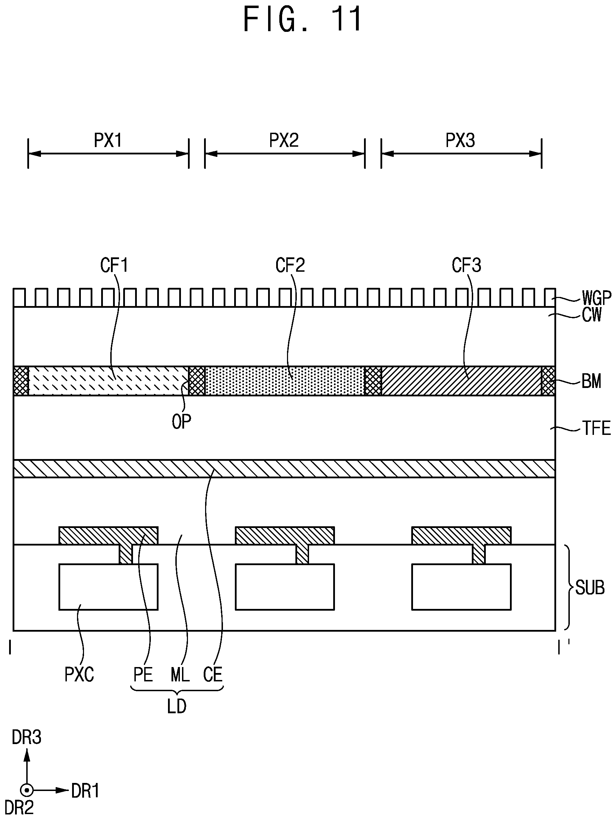

An embodiment of the display panel DP described with reference to FIG. 11 may be substantially the same or similar to the embodiment of the display panel DP described above with reference to FIG. 10 except for a position of the polarizing layer WGP. Hereinafter, overlapping descriptions may be omitted or simplified.

Referring to FIG. 11, in an embodiment, the polarizing layer WGP may be disposed on the cover window CW. The micro lenses (MLS, in FIG. 2) and the planarizing layers (OC, in FIG. 2) may be omitted. For example, the first to third color filters CF1, CF2, and CF3, the cover window CW, and the polarizing layer WGP may be sequentially disposed. However, similarly, the planarization layer OC may also be disposed between the polarizing layer WGP and the cover window CW.

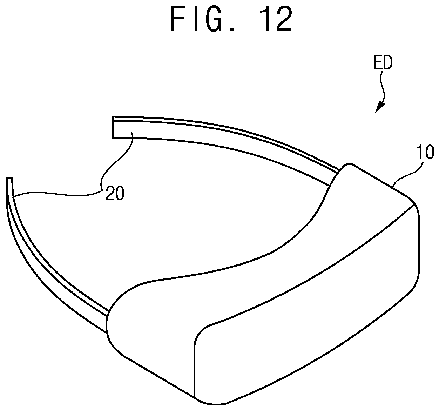

FIG. 12 is a schematic perspective view illustrating an electric device according to an embodiment.

Referring to FIG. 12, an electric device ED according to an embodiment of the disclosure may include a storage part 10 and glasses frame legs 20. For example, the electric device ED according to an embodiment may be implemented as a head mounted display. Therefore, hereinafter, the electric device ED will be described by taking the head-mounted display as an example.

The storage part 10 may include a display panel which displays an image and an optical member which provides the image displayed on the display panel to the user's eyes. Here, the display panel may correspond to the display panel DP illustrated in FIGS. 2 and 9 to 11. A detailed description of the storage part 10 will be described later.

The electric device ED may provide the image displayed on the display panel of the storage part 10 to the user through an eyepiece or the like. As a result, the electric device ED may provide a virtual image displayed by the display panel of the storage part 10 to the user. In other words, the electric device ED may implement virtual reality (VR).

The glasses frame legs 20 may be configured so that the user can readily put them on or take them off. However, the disclosure is not necessarily limited thereto, and the electric device ED may include a head-mounted band which can be mounted on a head instead of the glasses frame legs 20.

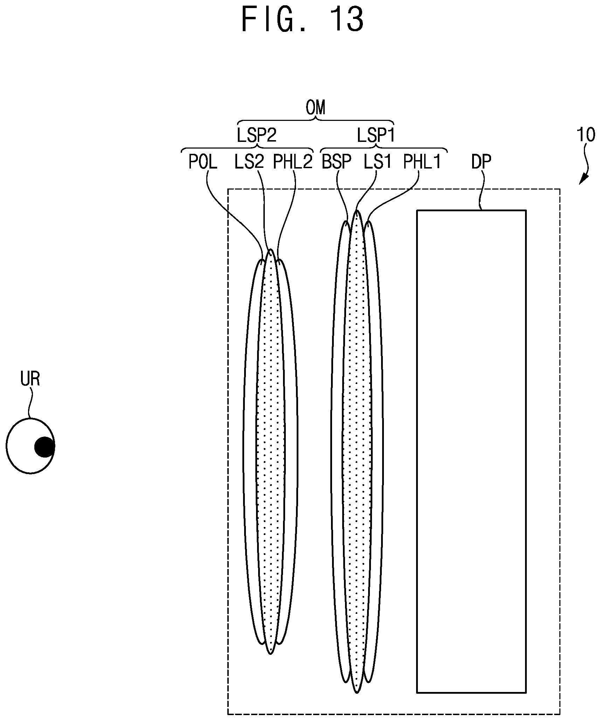

FIG. 13 is a side view illustrating an example of the storage part of the electric device of FIG. 12.

Referring to FIG. 13, the storage part 10 may include the display panel DP and an optical member OM.

The optical member OM may be located on a front of the display panel DP. For example, the optical member OM may be located between the display panel DP and the user UR (for example, eyes of the user UR). For example, the display panel DP and the optical member OM may be sequentially arranged along a normal direction of one plane. The optical member OM may improve a sense of immersion or three-dimensional effect by making light emitted from the display panel DP appear wider.

The display panel DP illustrated in FIG. 13 may correspond to the display panel DP illustrated in FIGS. 2 and 9 to 11. Therefore, the corresponding description may be omitted.

The optical member OM may include a first lens part LSP1 and a second lens part LSP2. The first lens part LSP1 may include a first lens LS1, a first phase retardation layer PHL1, and a beam splitter BSP. The second lens part LSP2 may include a second lens LS2, a second phase retardation layer PHL2, and a polarizer POL.

The first lens LS1 and the second lens LS2 may be curved lenses. A curved surfaces of the first lens LS1 and the second lens LS2 may be spherical or aspherical. In FIG. 13, both sides of the first lens LS1 are illustrated as being convex, but a shape of the first lens LS1 is not necessarily limited thereto. Each of the first lens LS1 and the second lens LS2 may include an optically isotropic material. For example, each of the first lens LS1 and the second lens LS2 may include glass or PMMA (polymethyl methacrylate).

The first phase retardation layer PHL1 may be disposed on one side or a side of the first lens LS1. For example, the first phase retardation layer PHL1 may be disposed on the display panel DP side of the first lens LS1. The first phase retardation layer PHL1 may have a retardation axis and provide a phase difference with respect to the retardation axis. For example, the first phase retardation layer PHL1 may provide a phase difference of $\lambda/4$ or $3\lambda/4$. Accordingly, the first phase retardation layer PHL1 may convert linearly polarized light into circularly polarized light or convert circularly polarized light into linearly polarized light by delaying light in a direction of the retardation axis by $\lambda/4$ or $3\lambda/4$.

The beam splitter BSP may be located on one side or a side of the first lens LS1. For example, the beam splitter BSP may be located on the user UR side of the first lens LS1. The beam splitter BSP may transmit some of the incident light and reflect the other of the incident light. The beam splitter BSP may reflect and transmit light regardless of polarization characteristics of the light. In an embodiment, the beam splitter BS may include a translucent metallic material.

The second phase retardation layer PHL2 may be disposed on one side or a side of the second lens LS2. For example, the second phase retardation layer PHL2 may be disposed on the first lens part LSP1 side of the second lens LS2. The second phase retardation layer PHL2 may have a retardation axis and provide a phase difference with respect to the retardation axis. For example, the second phase retardation layer PHL2 may provide a phase difference of $\lambda/4$ or $3\lambda/4$. Accordingly, the second phase retardation layer PHL2 may convert linearly polarized light into circularly polarized light or convert circularly polarized light into linearly polarized light by delaying light in a direction of the retardation axis by $\lambda/4$ or $3\lambda/4$.

The polarizer POL may be located on one side or a side of the second lens LS2. For example, the polarizer POL may be located on the user UR side of the second lens LS2.

In an embodiment, the polarizer POL may be a reflective polarizer. In this case, the polarizer POL may have a reflection axis. For example, the polarizer POL may reflect linearly polarized light in the same direction as the reflection axis. For example, linearly polarized light in the same direction as the reflection axis may not transmit through the polarizer POL. The polarizer POL may transmit linearly polarized light perpendicular to the reflection axis. For example, the polarizer POL may have a transmission axis perpendicular to the reflection axis.

As the storage part 10 may include the above-mentioned components, images may be provided to the user UR through the eyepiece, or the like. For example, some of the light emitted from the display panel DP may be transmitted through the first phase retardation layer PHL1, the first lens LS1, the beam splitter BSP, the second phase retardation layer PHL2, and the second lens LS2 and incident on the polarizer POL, some of the light incident on the polarizer POL may be reflected and incident on the beam splitter BSP, and some of the light incident on the beam splitter BSP may be reflected and reach the eyes of the user UR. Accordingly, an image displayed on the display panel DP may be provided to the user.

A structure of the storage part 10 described with reference to FIG. 13 is only an example, and the disclosure is not necessarily limited thereto. For example, components and stacked structure of the optical member OM may be determined in various ways depending on embodiments.

The disclosure can be applied to a display panel inspection device of various display devices. For example, the disclosure is applicable to a display panel inspection device of various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the disclosure. Accordingly, all such modifications are intended to be included within the scope of the invention as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims.

**Claims**

1. A display panel comprising:

   a base substrate including a pixel circuit;
   a pixel electrode disposed on the base substrate;
   a middle layer disposed on the pixel electrode, the middle layer including a light emitting material;
   a color filter disposed on the middle layer, the color filter including a phase retardation material which retards a phase of incident light; and
   a polarizing layer disposed on the color filter, the polarizing layer including a plurality of grid patterns spaced apart from each other at a selectable interval.

2. The display panel of claim 1, wherein the phase retardation material included in the color filter includes a polymer of a reactive mesogen.

3. The display panel of claim 1 or 2, wherein the color filter has a retardation axis and is configured to convert linearly polarized light into circularly polarized light or to convert circularly polarized light into linearly polarized light by delaying light in a direction of the retardation axis.

4. The display panel of claim 1, 2, or 3, wherein the color filter includes a colorant, optionally wherein the colorant included in the color filter is an isotropic colorant, further optionally wherein the isotropic colorant is a colorant in which an absorption rate for polarized light parallel to a long axis direction of a molecular structure and an absorption rate for polarized light perpendicular to the long axis direction are same, and/ or the color filter has a dichroic ratio of less than about 1.2.

5. The display panel of any one of claims 1 to 4, wherein the color filter has an in-plane phase difference in a range of about 100 nm to about 450 nm.

6. The display panel of any one of claims 1 to 5, wherein in an absorption spectrum of the color filter for light in a wavelength range of about 380 nm to about 780 nm, an absorption value of the color filter is greater than about 0 and less than or equal to about 2.

7. The display panel of any one of claims 1 to 6, further comprising a partition wall defining an opening, and wherein the color filter is disposed in the opening defined by the partition wall.

8. The display panel of any one of claims 1 to 7, wherein a difference between a height from an upper surface of the base substrate to a lower surface of the polarizing layer and a height from the upper surface of the base substrate to an upper surface of the pixel electrode is less than about 3.8 micrometers.

9. The display panel of any one of claims 1 to 8, further comprising:
a first pixel area where light is emitted at a first chief ray angle and a second pixel area where light is emitted at a second chief ray angle greater than the first chief ray angle, and wherein a horizontal separation distance between a center of an upper surface of the pixel electrode and a center of an upper surface of the color filter in a cross-sectional view of the second pixel area is greater than a horizontal separation distance between a center of an upper surface of the pixel electrode and a center of an upper surface of the color filter in a cross-sectional view of the first pixel area, optionally wherein the second pixel area is closer to an outer edge of the display panel than the first pixel area.

10. The display panel of any one of claims 1 to 9, wherein the grid patterns are metal patterns including a metal material.

11. The display panel of any one of claims 1 to 10, wherein the middle layer has a structure in which at least two or more light emitting layers are stacked each other.

12. The display panel of any one of claims 1 to 11, wherein the middle layer emits white light.

13. The display panel of any one of claims 1 to 12, wherein the base substrate is at least one of a silicon wafer including silicon and a sapphire substrate including sapphire.

14. The display panel of any one of claims 1 to 13, further comprising:

a plurality of micro lenses disposed on the color filter;
a planarization layer disposed on the micro lenses and covering the micro lenses; and
a cover window disposed on the planarization layer.

15. An electric device comprising:

a display panel as claimed in any one previous claim; and
an optical member disposed in a path of light emitted from the display panel, the optical member including a lens part.

# FIG. 1

EP 4 586 787 A1

# FIG. 2

# FIG. 3

ML

AL2

EML

AL1

DR3

# FIG. 4

ML

AL2

EMLb

CGL

EMLa

AL1

DR3

# FIG. 5

ML

AL2

EMLc

CGLb

EMLb

CGLa

EMLa

AL1

DR3

# FIG. 6

FIG. 7

FIG. 8

PX2
PE
CF2
BM
d11
CN1, CN2

PX2a
PE
CF2
BM
d11a
CN1 CN2

PX2b
PE
CF2
BM
d11b
CN1 CN2

DR3
DR1
DR2

# FIG. 9

# FIG. 10

PX1     PX2     PX3

CF1        CF2        CF3

CW

WGP

BM

OP

TFE

SUB

PXC    PE   ML   CE

LD

DR3

DR1

DR2

# FIG. 11

PX1     PX2     PX3

CF1     CF2     CF3

WGP
CW

BM

OP

TFE

SUB

PXC    PE   ML   CE

LD

DR3
DR1
DR2

FIG. 12

# FIG. 13

Europäisches
Patentamt

European
Patent Office

Office européen
des brevets

## EUROPEAN SEARCH REPORT

**Application Number**

EP 24 21 4153

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/307759 A1 (JANG YONG-KYU [KR]) 21 November 2013 (2013-11-21) * paragraphs [0051] - [0054]; figure 6 * ----- | 1,2,4,6, 7,10-15 | INV. H10K59/38 H10K59/80 |
| X | JP 2010 085615 A (FUJIFILM CORP) 15 April 2010 (2010-04-15) * paragraphs [0035] - [0069], [0081], [0121] - [0153] * ----- | 1,3-7,12 | |
| A | US 2015/028296 A1 (JEONG CHANG-YONG [KR] ET AL) 29 January 2015 (2015-01-29) * paragraphs [0041] - [0047], [0066] - [0098]; figures 2,6 * ----- | 1-15 | |

**TECHNICAL FIELDS SEARCHED (IPC)**

H10K
G02B

The present search report has been drawn up for all claims

| Place of search | Date of completion of the search | Examiner |
|---|---|---|
| The Hague | 7 May 2025 | Bakos, Tamás |

## ANNEX TO THE EUROPEAN SEARCH REPORT
## ON EUROPEAN PATENT APPLICATION NO.

EP 24 21 4153

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2025

| Patent document cited in search report | Publication date | Patent family member(s) | Publication date |
|---|---|---|---|
| US 2013307759 A1 | 21-11-2013 | KR 20130128913 A | 27-11-2013 |
| | | US 2013307759 A1 | 21-11-2013 |
| JP 2010085615 A | 15-04-2010 | NONE | |
| US 2015028296 A1 | 29-01-2015 | KR 20150011708 A | 02-02-2015 |
| | | US 2015028296 A1 | 29-01-2015 |

For more details about this annex : see Official Journal of the European Patent Office, No. 12/82